# EUROPÄISCHE PATENTANMELDUNG

(11) **EP 0 907 203 A2**
(43) Veröffentlichungstag der Anmeldung: **07.04.1999**
(21) Anmeldenummer: 98114639.2
(22) Anmeldetag: 30.07.1998
(51) Int. Cl.: H01L 21/311, H01L 21/3213, H01L 21/3205

(54) **Strukturierungsverfahren**

(30) Priorität: 03.09.1997 DE 19738591
(71) Anmelder: SIEMENS AKTIENGESELLSCHAFT, 80333 München (DE)
(72) Erfinder: Engelhardt, Manfred Dr., 83620 Feldkirchen-Westerham (DE); Weinrich, Volker, Dr., 81549 München (DE)

(57) **Zusammenfassung**

Erfindungsgemäß wird ein Verfahren zur Strukturierung zumindest einer zu strukturierenden Schicht bereitgestellt, das die folgenden Schritte umfaßt: auf die zu strukturierende Schicht wird eine Maske aufgebracht, die zu strukturierende Schicht wird unter Verwendung der Maske strukturiert, die Maske wird entfernt, wobei Redepositionen des Materials der zu strukturierenden Schicht zurückbleiben, und die Redepositionen des Materials der zu strukturierenden Schicht werden durch Schalleinwirkung entfernt.

## Beschreibung

Die vorliegende Erfindung betrifft ein Strukturierungsverfahren, insbesondere ein Verfahren zur Strukturierung von plasma- oder trocken-chemisch nur schwer oder nicht ätzbaren Schichten wie beispielsweise Schichten aus Edelmetallen, ferroelektrischen Materialien sowie dielektrischen Materialien mit hoher relativer Dielektrizitätskonstante.

Bei der Entwicklung von hochintegrierten Speicherbausteinen, wie z.B. DRAMs bzw. FRAMs sollte die Zellkapazität bei der fortschreitenden Miniaturisierung beibehalten oder sogar noch verbessert werden. Zur Erreichung dieses Ziels werden immer dünnere dielektrische Schichten und gefaltete Kondensatorelektroden (Trench-Zelle, Stack-Zelle) verwendet. In letzter Zeit werden anstatt des herkömmlichen Siliziumoxids neue Materialien, insbesondere Paraelektrika und Ferroelektrika, zwischen den Kondensatorelektroden einer Speicherzelle verwendet. Beispielsweise kommen Bariumstrontiumtitanat (BST, (Ba,Sr)TiO₃), Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) für die Kondensatoren der Speicherzellen bei DRAMs bzw. FRAMs zum Einsatz.

Dabei werden diese Materialien üblicherweise auf bereits vorhandenen Elektroden (Bodenelektroden) abgeschieden. Die Prozessierung erfolgt unter hohen Temperaturen, so daß die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangsmetalle, insbesondere Platinmetalle (Ru, Rh, Pd, Os, Ir, Pt) und insbesondere Platin selbst, sowie Rhenium als aussichtsreiche Kandidaten, die dotiertes Polysilizium als Elektrodenmaterial in den obengenannten Speicherzellen ersetzen könnten.

Die fortschreitende Miniaturisierung der Bauelemente hat ebenfalls zur Folge, daß Ersatzmaterialien für das heute für die Leiterbahnen verwendete Aluminium erforderlich werden. Dabei sollte das Ersatzmaterial einen geringeren spezifischen Widerstand und eine geringere Elektromigration als Aluminium aufweisen. Als aussichtsreichster Kandidat gilt dabei Kupfer.

Weiterhin erfordert die Entwicklung magnetischer 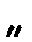 Random Access Memories" (MRAMs) die Integration magnetischer Schichten (z.B. Fe, Co, Ni oder Permalloy) in mikroelektronische Schaltungen.

Um aus den genannten, bisher in der Halbleitertechnologie noch nicht verbreiteten Materialien eine integrierte Schaltung aufbauen zu können, müssen dünne Schichten dieser Materialien strukturiert werden.

Die Strukturierung der bisher verwendeten Materialien erfolgt in der Regel durch sogenannte plasmaunterstützte anisotrope Ätzverfahren. Dabei werden üblicherweise physikalisch-chemische Verfahren angewandt, bei denen Gasgemische aus einem oder mehreren reaktiven Gasen, wie z.B. Sauerstoff, Chlor, Brom, Chlorwasserstoff, Bromwasserstoff bzw. halogenierten Kohlenwasserstoffen und aus Edelgasen (z.B. Ar, He) verwendet werden. Diese Gasgemische werden in der Regel in einem elektromagnetischen Wechselfeld bei geringen Drücken angeregt.

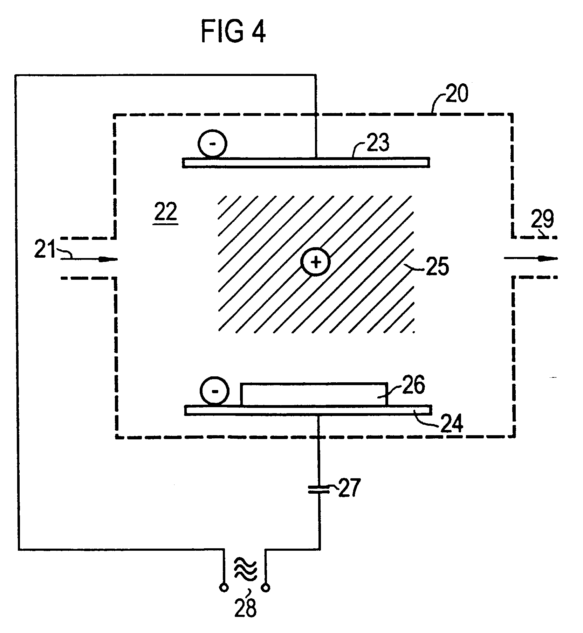

Fig. 4 zeigt die prinzipielle Arbeitsweise einer Ätzkammer, dargestellt am Beispiel eines Parallelplattenreaktors 20. Das Gasgemisch, z.B. Ar und Cl₂, wird über den Gaseinlass 21 der eigentlichen Reaktorkammer 22 zugeführt und durch den Gasauslass 29 wieder abgepumpt. Die untere Platte 24 des Parallelplattenreaktors ist über eine Kapazität 27 mit einer Hochfrequenzquelle 28 verbunden und dient als Substrathalter. Durch das Anlegen eines hochfrequenten elektrischen Wechselfeldes an die obere und die untere Platte 23, 24 des Parallelplattenreaktors wird das Gasgemisch in ein Plasma 25 überführt. Da die Beweglichkeit der Elektronen größer als die der Gaskationen ist, laden sich die obere und die untere Platte 23, 24 gegenüber dem Plasma 25 negativ auf. Daher üben beide Platten 23, 24 auf die positiv geladenen Gaskationen eine hohe Anziehungskraft aus, so daß sie einem permanenten Bombardement durch diese Ionen, z.B. Ar⁺ ausgesetzt sind. Da der Gasdruck zudem niedrig gehalten wird, typischerweise 0.1 - 10 Pa, findet nur eine geringfügige Streuung der Ionen untereinander und an den Neutralteilchen statt, und die Ionen treffen nahezu senkrecht auf die Oberfläche eines Substrats 26, das auf der unteren Platte 24 des Parallelplattenreaktors gehalten ist. Dies erlaubt eine gute Abbildung einer Maske (nicht gezeigt) auf die darunterliegende, zu ätzende Schicht des Substrats 26.

Üblicherweise werden als Maskenmaterialien Photolacke verwendet, da diese durch einen Belichtungsschritt und einen Entwicklungsschritt relativ einfach strukturiert werden können.

Der physikalische Teil der Ätzung wird durch Impuls und kinetische Energie der auftreffenden Ionen (z.B. Cl₂⁺, Ar⁺) bewirkt. Zusätzlich werden dadurch chemische Reaktionen zwischen dem Substrat und den reaktiven Gasteilchen (Ionen, Moleküle, Atome, Radikale) unter Bildung flüchtiger Reaktionsprodukte initiiert oder verstärkt (chemischer Teil der Ätzung). Diese chemischen Reaktionen zwischen den Substratteilchen und den Gasteilchen sind verantwortlich für hohe Ätzselektivitäten des Ätzprozesses.

Leider hat sich herausgestellt, daß die oben genannten, in integrierten Schaltungen neu eingesetzten Materialien zu den chemisch nur schwer oder nicht ätzbaren Materialien gehören, bei denen der Ätzabtrag, auch bei der Verwendung 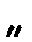 reaktiver" Gase, überwiegend oder fast ausschließlich auf dem physikalischen Anteil der Ätzung beruht.

Wegen der geringen oder fehlenden chemischen Komponente der Ätzung liegt der Ätzabtrag der zu strukturienden Schicht in der selben Größenordnung wie der Ätzabtrag der Maske bzw. der Unterlage (Ätzstoppschicht), d.h. die Ätzselektivität zur Ätzmaske bzw. Unterlage ist im allgemeinen klein (zwischen etwa 0,3 und 3,0). Dies hat zur Folge, daß durch die Erosion von Masken mit geneigten Flanken und die unvermeidliche Facettenbildung (Abschrägung, Taperung) auf den Masken nur eine geringe Maßhaltigkeit der Strukturierung gewährleistet werden kann. Diese Facettierung beschränkt somit die bei der Strukturierung kleinsten erzielbaren Strukturgrößen sowie die erzielbare Steilheit der Profilflanken bei den zu strukturierenden Schichten.

Dabei ist die Facettierung auf den Masken, und damit auch die Facettierung der zu strukturierenden Schichten, umso größer je größer der Anteil der reaktiven Gase (insbesondere Chlor) am Gasgemisch ist, das während des plasma-chemischen Ätzverfahrens verwendet wird. Dementsprechend lassen sich mit Gasgemischen, die keinen Anteil an reaktiven Gasen aufweisen, beispielsweise reine Argonplasmen, die steilsten Profilflanken bei den zu strukturierenden Schichten erzeugen.

Zusätzlich zu der genannten Facettierung der zu strukturierenden Schichten kann es bei der Strukturierung auch zu unerwünschten Redepositionen des Materials der zu strukturierenden Schicht kommen. Diese Redepositionen treten beispielsweise an den Seitenwänden der Lackmaske auf und sie konnten bislang in nachfolgenden Nachbehandlungsschritten nur unvollständig oder gar nicht entfernt werden. Leider treten die Redepositionen umso massiver auf je kleiner der Anteil der reaktiven Gase am Gasgemisch ist, das während des plasma-chemischen Ätzverfahrens verwendet wird. Dementsprechend war die Prozeßführung bisher meist auf geringe Argonanteile beispielsweise in einem Chlor-Argon-Plasma beschränkt. Der erhöhte Chloranteil im Ätzgasgemisch führt jedoch wiederum zu einer erhöhten Facettenbildung der Masken.

Im Falle des Platin-Ätzens mit einer Lackmaske hat die Verwendung reaktiver Gase wie Chlor oder HBr zur Folge, daß sich intermediäre Redepositionen bilden, welche im weiteren Verlauf der Ätzung wieder verschwinden. Auch diese Strukturen führen zu einer CD-Aufweitung und zu flachen Platinflanken. Sie gelten inzwischen als der größte Nachteil eines Prozesses, der sowohl Chlor als auch eine Lackmaske verwendet.

Wird anstatt einer Lackmaske eine sogenannte 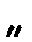 Hard Mask" zur Strukturierung der zu strukturierenden Schichten verwendet, so können viele der genannten Schwierigkeiten deutlich vermindert werden. Die Strukturierung einer 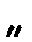 Hard Mask" benötigt jedoch zusätzliche Prozeßschritte, welche den Gesamtprozeß verteuern.

Es ist daher die Aufgabe der vorliegenden Erfindung, ein Strukturierungsverfahren bereitzustellen, das die genannten Nachteile der bisherigen Verfahren vermeidet oder mindert.

Diese Aufgabe wird von dem Verfahren gemäß Patentanspruch 1 oder Patentanspruch 3 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Strukturierung zumindest einer zu strukturierenden Schicht bereitgestellt, das die folgenden Schritte umfaßt:
auf die zu strukturierende Schicht wird eine Maske aufgebracht,
die zu strukturierende Schicht wird unter Verwendung der Maske strukturiert,
die Maske wird entfernt, wobei Redepositionen des Materials der zu strukturierenden Schicht zurückbleiben, und
die Redepositionen des Materials der zu strukturierenden Schicht werden unter Schalleinwirkung entfernt.

Es hat sich herausgestellt, daß unter Schalleinwirkung die Redepositionen des Materials der zu strukturierenden Schicht, die mit den üblichen chemischen Methoden nur schwer zu entfernen waren, relativ einfach und zuverlässig entfernt werden können, ohne daß die bereits auf dem Wafer erzeugten Strukturen beschädigt oder zerstört werden. Das erfindungsgemäße Verfahren hat somit den Vorteil, daß die zur eigentlichen Strukturierung der zu strukturierenden Schicht eingesetzten Verfahren, z.B. plasmachemische Ätzverfahren, ohne Rücksicht auf die Frage ausgewählt werden können, ob diese Verfahren zu erhöhten Redepositionen führen. So können beispielsweise plasmachemische Ätzverfahren mit reinen Argonplasmen verwendet werden. Dies hat zur Folge, daß jetzt auch gewöhnliche Lackmasken verwendet werden können, ohne daß es, wie bei der Verwendung reaktiver Gase, zu übermäßigen Facettenbildungen auf den Masken kommt.

Weiterhin wird erfindungsgemäß ein Verfahren zur Strukturierung zumindest einer zu strukturierenden Schicht bereitgestellt, das die folgenden Schritte umfaßt:
auf die zu strukturierende Schicht wird eine Maske aufgebracht,
die zu strukturierende Schicht wird unter Verwendung der Maske strukturiert,
die Maske und die Redepositionen des Materials der zu strukturierenden Schicht werden unter Schalleinwirkung entfernt.

Durch das gleichzeitige Entfernen der Maske und der Redepositionen kann ein Prozeßschritt eingespart werden. Es ergibt sich damit eine insgesamt einfachere und billigere Prozeßführung. Falls die Maske eine Lackmaske ist, sind bevorzugte Medien für die kombinierte Entfernung von Lack und Redepositionen: EKC 265, Stripper 106, N-Methylpyrrolidon (NMP), Caro'sche Säure, sogenannte 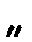 rauchende Salpetersäure" oder KOH.

Bevorzugt erfolgt die Schalleinwirkung über ein flüssiges Medium, insbesondere durch ein Ultraschallbad, durch eine Megasonic-Anlage oder durch einen mit Schall beaufschlagten Flüssigkeitsstrahl.

Bevorzugt wird nach der Entfernung der Redepositionen eine 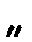 Scrubber"-Reinigung durchgeführt. Zusätzlich oder alternativ kann nach der Entfernung der Redepositionen auch eine naßchemische Reinigung, insbesondere unterstützt durch eine nochmalige Schalleinwirkung (Ultraschall, Finesonic), durchgeführt werden.

Bevorzugt enthält die zu strukturierende Schicht Kupfer, Eisen, Kobalt, Nickel, ein 4d oder 5d Übergangsmetall, insbesondere ein Platinmetall.

Weiterhin ist es bevorzugt, wenn die zu strukturierende Schicht ein ferroelektrisches Material, ein dielektrisches Material hoher relativer Dielektrizitätskonstanten (> 20), einen Perowskit oder Vorstufen dieser Materialien enthält. Dabei soll unter einer Vorstufe der genannten Materialien ein Material verstanden werden, das durch eine geeignete Wärmebehandlung (z.B. Tempern), gegebenenfalls unter Zuführung von Sauerstoff, in die genannten Materialien umgewandelt werden kann.

So ist es bevorzugt, wenn die zu strukturierende Schicht Strontiumwismuttantalat (SBT, SrBi₂Ta₂O₉), Strontiumwismutniobattantalat (SBNT, SrBi₂Ta₂₋ₓNbₓO₉, x=0-2) Bleizirkonattitanat (PZT, Pb(Zr,Ti)O₃) oder Derivate sowie Bariumstrontiumtitanat (BST, BaₓSr₁₋ₓTiO₃, x=0-1), Bleilanthantitanat (PLT, (Pb, La)TiO₃), Bleilanthanzirkonattitanat (PLZT, (Pb, La)(Zr, Ti)O₃) oder Derivate enthält.

Weiterhin ist es bevorzugt, wenn die zu strukturierende Schicht Platin, Gold, Silber, Kupfer, Iridium, Palladium, Ruthenium, Rhenium oder deren Oxide enthält.

Bevorzugt wird zum Strukturieren der zu strukturierenden Schicht ein Trockenätzverfahren, insbesondere ein Plasmaätzverfahren verwendet.

Dabei ist insbesondere bevorzugt, wenn während der Trockenätzung der zu strukturienden Schicht ein Gasgemisch vorgesehen ist, das frei von reaktiven Gasen ist.

Weiterhin ist es bevorzugt, wenn während der Trockenätzung der zu strukturienden Schicht ein Edelgas, insbesondere Argon, vorgesehen ist.

Darüberhinaus ist es bevorzugt, wenn die Schallfrequenz des verwendeten Schalls über einen vorbestimmten Frequenzbereich verändert wird. So lassen sich auch Redepositionen mit unterschiedlichen Abmessungen wirksam entfernen.

Die Erfindung wird nachfolgend anhand von Figuren der Zeichnung näher dargestellt. Es zeigen:
Fig. 1 bis 3 eine schematische Darstellung des erfindungsgemäßen Verfahrens, und
Fig. 4 eine schematische Darstellung einer Ätzkammer in Form eines Parallelplattenreaktors.

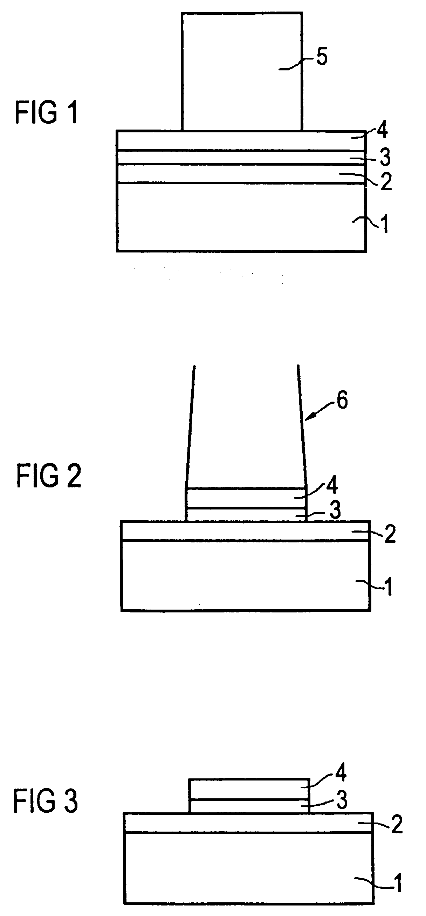

Die Figuren 1 bis 3 zeigen eine schematische Darstellung des erfindungsgemäßen Verfahrens. Auf einem Substrat 1 wird eine SiO₂-Schicht 2 aufgebracht. Es folgt Haft- oder Barriereschicht 3, die aus Titan bzw. Titannitrid besteht. Auf die Haft- oder Barriereschicht 3 wird eine Platinschicht 4 als zu strukturiende Schicht beispielsweise durch Sputtern aufgebracht. Auf der Platinschicht 4 wird eine Lackschicht gebildet, welche später als Maske 5 für die Strukturierung der Platinschicht 4 dient. Die Lackschicht wird durch einen Belichtungs- und einen Entwicklungsschritt strukturiert. Die sich daraus ergebende Struktur ist in Fig. 1 gezeigt.

Nachfolgend wird ein Ionenätzen oder Sputterätzen durchgeführt, um die Platinschicht 4 einem physikalischen Trockenätzen zu unterziehen. Als Ätzgas wird dabei ein reines Argongas verwendet. Anstatt des Ionenätzens können auch andere Plasmaätzverfahren wie beispielsweise das reaktive Ionenätzen (RIE, Reactive Ion Etching), das magnetfeldunterstützte reaktive Ionenätzen (MERIE, Magnetically Enhanced RIE), das ECR-Ätzen (ECR, Electron Cyclotron Resonance) oder induktiv gekoppelte Plasmaätzverfahren (ICP, TCP) eingesetzt werden.

Da als Ätzgas reines Argon eingesetzt werden kann, kommt es zu keiner zu starken Facettierung der Maske 5. Dementsprechend ist auch die Erosion der Maske 5 gering. Durch die geringere Maskenerosion ergibt sich eine höhere Maßhaltigkeit der Strukturierung. Darüber hinaus lassen sich somit steilere Ätzflanken an der zu strukturienden Schicht erzielen. Ätzflanken mit einem Flankenwinkel von über 80° können erzeugt werden.

Durch die fehlende chemische Komponente kommt es während des Trockenätzens zu Redepositionen 6 von Platin an den Seitenwänden der Lackmaske 5. Diese Platinredepositionen 6 waren bisher mit den üblichen chemischen Verfahren nur schwer oder gar nicht wieder zu entfernen.

Zur Entfernung der Lackmaske 5 folgt eine Lackveraschung. Dabei bleiben freistehende Platinredepositionen 6 auf der Oberfläche der strukturierten Platinschicht 4 zurück. Die sich daraus ergebende Struktur ist in Fig. 2 gezeigt.

Anschließend werden die Redepositionen 6 durch unter Schalleinwirkung entfernt. Dazu kann beispielsweise ein Ultraschallbad (Bandelin Sonorex Super RK 255 H) verwendet werden. Die in Fig. 2 gezeigte Struktur wird dazu in ein flüssiges Medium getaucht. Im vorliegenden Fall wurde die Struktur in das Lösungsmittel N-Methylpyrrolidon (NMP) getaucht. Dabei hatte das Lösungsmittel eine Temperatur von etwa 65°C. Nachfolgend wird ein Ultraschall mit einer Frequenz von etwa 35 kHz und einer Leistung von 2*320 Watt in das flüssige Medium eingekopelt. Unter dem Einfluß des Ultraschalls können die Redepositionen 6 relativ einfach und zuverlässig entfernt werden, ohne daß die bereits auf dem Wafer erzeugten Strukturen beschädigt oder zerstört werden.

Es folgt eine 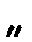 Scrubber"-Reinigung. Zusätzlich oder alternativ kann nach der Entfernung der Redepositionen 6 auch eine naßchemische Reinigung z.B. mit stark verdünnter HF-Säure, bevorzugt unterstützt durch Schalleinwirkung, durchgeführt werden. Dies führt zur chemischen Anlösung der zwischen den Platinstrukturen freiliegenden SiO₂-Oberfläche und zu einer mechanisch unterstützten Entfernung von Partikeln aus diesen Bereichen. Die sich daraus ergebende Struktur ist in Fig. 3 gezeigt.

## Patentansprüche

1. Verfahren zur Strukturierung zumindest einer zu strukturierenden Schicht mit den Schritten:
- auf die zu strukturierende Schicht wird eine Maske aufgebracht,
- die zu strukturierende Schicht wird unter Verwendung der Maske strukturiert,
- die Maske wird entfernt, wobei Redepositionen des Materials der zu strukturierenden Schicht zurückbleiben, und
- die Redepositionen des Materials der zu strukturierenden Schicht werden unter Schalleinwirkung entfernt.

2. Verfahren nach Anspruch 1,
**dadurch gekennzeichnet,** daß
die Maske eine Lackmaske ist, welche bevorzugt durch Veraschen entfernt wird.

3. Verfahren zur Strukturierung zumindest einer zu strukturierenden Schicht mit den Schritten:
- auf die zu strukturierende. Schicht wird eine Maske aufgebracht,
- die zu strukturierende Schicht wird unter Verwendung der Maske strukturiert,
- die Maske und die Redepositionen des Materials der zu strukturierenden Schicht werden unter Schalleinwirkung entfernt.

4. Verfahren nach einem der Ansprüche 1 bis 3,
**dadurch gekennzeichnet,** daß
die Schalleinwirkung durch ein Ultraschallbad, durch eine Megasonic-Anlage oder durch einen mit Schall beaufschlagten Flüssigkeitsstrahl erfolgt.

5. Verfahren nach einem der Ansprüche 1 bis 4,
**dadurch gekennzeichnet,** daß
nach der Entfernung der Redepositionen eine 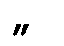 Scrubber"-Reinigung durchgeführt wird.

6. Verfahren nach einem der Ansprüche 1 bis 5,
**dadurch gekennzeichnet,** daß
nach der Entfernung der Redepositionen eine naßchemische Reinigung durchgeführt wird.

7. Verfahren nach einem der Ansprüche 5 oder 6,
**dadurch gekennzeichnet,** daß
die Reinigung durch Schalleinwirkung unterstützt wird.

8. Verfahren nach einem der Ansprüche 1 bis 7,
**dadurch gekennzeichnet,** daß
die zu strukturierende Schicht Kupfer, Eisen, Kobalt, Nickel, ein 4d oder 5d Übergangsmetall, insbesondere ein Platinmetall, enthält.

9. Verfahren nach einem der Ansprüche 1 bis 7,
**dadurch gekennzeichnet,** daß
die zu strukturierende Schicht ein ferroelektrisches Material, ein dielektrisches Material hoher Permittivität, einen Perowskit oder Vorstufen dieser Materialien enthält.

10. Verfahren nach Anspruch 9,
**dadurch gekennzeichnet,** daß
die zu strukturierende Schicht Strontiumwismuttantalat (SBT, SrBi₂Ta₂O₉), Strontiumwismutniobattantalat (SBNT, SrBi₂Ta₂₋ₓNbₓO₉, x=0-2), Bleizirkonattitanat (PZT, Pb(Zr,Ti)O₃) oder Derivate oder Bariumstrontiumtitanat (BST, BaₓSr₁₋ₓTiO₃, x=0-1), Bleilanthantitanat (PLT, (Pb, La)TiO₃), Bleilanthanzirkonattitanat (PLZT, (Pb, La)(Zr, Ti)O₃) oder Derivate enthält.

11. Verfahren nach Anspruch 8,
**dadurch gekennzeichnet,** daß
die zu strukturierende Schicht Platin, Gold, Silber, Iridium, Palladium, Ruthenium, Rhenium oder deren Oxide enthält.

12. Verfahren nach einem der vorherstehenden Ansprüche,
**dadurch gekennzeichnet,** daß
während der Trockenätzung der zu strukturienden Schicht ein Gasgemisch vorgesehen ist, das frei von reaktiven Gasen ist.

13. Verfahren nach einem der vorherstehenden Ansprüche,
**dadurch gekennzeichnet,** daß
während der Trockenätzung der zu strukturienden Schicht ein Gasgemisch vorgesehen ist, das neben Edelgasen und Stickstoff nur Sauerstoff enthält.

14. Verfahren nach einem der vorherstehenden Ansprüche,
**dadurch gekennzeichnet,** daß
während der Trockenätzung der zu strukturienden Schicht ein Edelgas, insbesondere Argon, vorgesehen ist.

15. Verfahren nach einem der Ansprüche 1 bis 14,
**dadurch gekennzeichnet,** daß
die Maske Silizium, ein Siliziumoxid, insbesondere SiO₂, ein Metall, insbesondere Aluminium oder Wolfram, ein Metallnitrid, bevorzugt ein Titannitrid, insbesondere TiNₓ 0.8 < x < 1.2, oder ein Metallsilizid enthält.

16. Verfahren nach einem der vorherstehenden Ansprüche,
**dadurch gekennzeichnet,** daß
die Schallfrequenz des verwendeten Schalls über einen vorbestimmten Frequenzbereich verändert wird.
